# EUROPEAN PATENT SPECIFICATION

(11) **EP 0 661 596 B1**
(45) Date of publication and mention of the grant of the patent: **01.04.1998**
(21) Application number: 93203567.8
(22) Date of filing: 17.12.1993
(51) Int. Cl.: G03F 7/07, G03C 8/06

(54) **Imaging element and method for making a lithographic printing plate according to the silver salt diffusion transfer process**
Bildelement und Verfahren zur Herstellung einer lithographischen Druckplatte durch das Silbersalzdiffusionübertragungsverfahren
Elément d'image et procédé de fabrication d'une plaque d'impression lithographique suivant le procédé de diffusion-transfert de sel d'argent

(43) Date of publication of application: 05.07.1995
(73) Proprietor: AGFA-GEVAERT N.V., 2640 Mortsel (BE)
(72) Inventor: Vaes, Jos, Septestraat 27, B-2640 Mortsel (BE); Van Thillo, Etienne, Septestraat 27, B-2640 Mortsel (BE)

(56) References cited:
- EP-A- 0 532 076
- US-A- 4 510 228

## Description

### 1. Field of the invention.

The present invention relates to an imaging element for making a lithographic printing plate according to the silver salt diffusion transfer process and more in particular to an imaging element that can yield printing plates having improved lithographic printing properties such as an increased printing endurance.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method. For example the United Kingdom Patent Specification 1,241,661 discloses a method for the production of a planographic printing plate consisting of a sheet material comprising an outer hydrophilic colloid layer on the surface of which there is concentrated a silver image stemming from an underlying exposed silver halide emulsion layer by the silver complex diffusion transfer reversal process. The silver image formed on the surface is suitable for printing images in a lithographic printing process using a dampening liquid.

Commercial lithographic printing plate precursors of the latter type typically contain on a support in the order given a base layer serving as an anti-halation layer, a silver halide emulsion layer and a surface layer containing physical development nuclei in which the silver image is formed.

Numerous attempts have been made to improve the lithographic printing properties especially the printing endurance of a lithographic printing plate obtained using a lithographic printing plate precursor as described above. These attempts are illustrated by the following disclosures.

The US patents US-4,297,429, US-4,297,430 and US-4,355,290 disclose the use of respectively cyclic imides, oxazolidones and 2-mercaptobenzoic acid as silver halide solvents in the DTR-process for improving the lithographic printing properties. Japanese patent no 1,355,795 discloses an imaging element as lithographic printing plate precursor containing most of the matting agent used in the base layer comprised between the support and the photosensitive silver halide emulsion layer. In DE 39 06 676 it is disclosed to include an intermediate hydrophilic layer between the photosensitive layer and the layer containing physical development nuclei for increasing the printing endurance. For the same purpose US-4,772,535 discloses the use of a light insensitive silver halide layer between the support and the photosensitive silver halide layer. EP 532076 discloses a method for producing a lithographic printing plate precursor wherein at least one of the hydrophilic colloid layers is coated from a solution containing at least 7.5% of said hydrophilic colloid. A lithographic printing plate precursor thus obtained yields printing plates with an increased printing endurance.

US 4.510.228 discloses that all gelatine containing layers located between the physical development nuclei layer and the support should have a pH below the iso-electric point of the gelatin used in each layer to obtain in an increased printing endurance. It is further disclosed in US 4.510.228 that the improved printing endurance is not obtained if the base layer or silver halide emulsion layer has a pH above the iso-electric point of the gelatine. Still other disclosures relating to the improvement of the lithographic printing properties of DTR-monosheet printing plates are well known to the person skilled in the art.

Despite these numerous publications the need still exists for further improving the printing properties especially the printing endurance of DTR-monosheet printing plates and reducing the number of useless copies at the start of the printing process.

### 3. Summary of the invention.

It is an object of the present invention to provide an imaging element for making a lithographic printing plate with improved lithographic printing properties, in particular an increased printing endurance, according to the silver salt diffusion transfer process.

It is a further object of the present invention to provide a method for obtaining an improved printing plate in accordance with the silver salt diffusion transfer process.

Further objects will become clear from the description hereinafter.

According to the present invention there is provided an imaging element comprising on a support in the order given (i) a subbing layer comprising gelatine, (ii) a base layer containing an anti-halation substance, (iii) a silver halide emulsion layer and (iv) an image receiving layer containing physical development nuclei characterised in that said subbing layer has a pH above the iso-electric point of the gelatine used in said subbing layer.

According to the present invention there is provided a method for making a lithographic printing plate comprising the steps of image-wise exposing an imaging element as defined above and subsequently developing a thus obtained image-wise exposed imaging element using an alkaline processing solution in the presence of a developing agent and a silver halide solvent.

### 4. Detailed description of the invention.

It has been found that the printing endurance of a lithographic printing plate obtained according to the DTR-process can be improved by using an imaging element being provided with a subbing layer having a pH above the iso-electric point of the gelatine used in the subbing layer. Preferably the pH of the subbing layer is at least 0.3 units above the iso-electric point of the gelatine in the subbing layer.

The iso-electric point of commonly used gelatines in a photographic element is around 4.8, however modified gelatines e.g. phtaloyl gelatine, having a lower iso-electric point can also be used in the subbing layer in accordance with the present invention. It is also possible to use a mixture of gelatines, having different iso-electric points, in the subbing layer in connection with the present invention. In the latter case the pH of the subbing layer should be above the iso-electric point of the gelatine having the highest iso-electric point.

The gelatine for use in the subbing layer in connection with the present invention may be of the high-viscosity, middle-viscosity or low-viscosity type. Mixtures of e.g. a high and low viscosity gelatine may also be used in the subbing layer in connection with the present invention.

According to a highly preferred embodiment the subbing layer is contiguous to the base layer. The amount of gelatine used in the subbing layer in connection with the present invention is preferably between 0.1g/m² and 1.5g/m² and more preferably between 0.2g/m² and 0.9g/m². The subbing layer in accordance with the present invention is preferably not hardened.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer.

The base layer for use in connection with the present invention contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titaniumdioxide can be present in the base layer. Further this layer can contain hardening agents, matting agents, e.g. silica particles, and wetting agents. Suitable matting agents preferably have an average diameter of 2-10µm and more preferably between 2µm and 5µm. The matting agents are generally used in a total amount in the imaging element of 0.1g/m² to 2.5g/m². At least part of these matting agents and/or light reflection pigments may also be present in the silver halide emulsion layer the most part, preferably at least 80% by weight however preferably being present in said base-layer. As a further alternative the light reflecting pigments may be present in a separate layer provided between the antihalation layer and the photosensitive silver halide emulsion layer. Like the emulsion layer the base layer is coated preferably at a pH value below the isoelectric point of the gelatin in the base layer.

The photographic silver halide emulsions can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide is present ranging from 1 mole % to 40 mole %. The emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated.

The average size of the silver halide grains may range from 0.10 to 0.70 µm , preferably from 0.25 to 0.45 µm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Rhodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217,

More details about the composition, preparation and coating of silver halide emulsions can be found in e.g. Product Licensing Index, Vol. 92, December 1971, publication 9232, p. 107-109.

The layer containing physical development nuclei is preferably free of hydrophilic binder but may comprise small amounts up to 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a multiple layer pack e.g. a double layer pack.

The hydrophilic layers usually contain gelatin as hydrophilic colloid binder. Mixtures of different gelatins with different viscosities can be used to adjust the rheological properties of the layer. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The hardening level of the layer package on the photosensitive side of the imaging element that will also form the printing side is an important factor in controlling the printing endurance of the lithographic printing plate obtained from such an imaging element. When the hardening level is too low the printing endurance will also be low while a too high hardening level will also yield low printing endurances since this will object the diffusion of the silver halide complexed by the silver solvent to the image receiving layer of physical development nuclei so that the strength of the silver image on the surface will be small.

The hardening level of a gelatine layer package on the photosensitive side of the imaging element can be determined using enzymatic hydrolysis of the gelatine. The procedure is as follows.

The photosensitive side of the imaging element is swollen in a buffer solution at pH=7. After 5min. an aqueous solution of 2% of protease 660L (commercially avalaible from Solvay) is applied to the swollen layers and the decrease of the thickness of the layers is measured with time. The procedure is carried out at 49°C. Since the enzymatic hydrolysis is directly related to the hardening level the hardening level can be expressed as the rate of hydrolysis under the above described conditions.
The hardening level of the layer package on the photosensitive side of the imaging element according to the present invention is preferably between 0.4∗10⁻²µm/s and 1.5∗10⁻²µm/s expressed as the rate of decrease of the layer thickness under enzymatic hydrolysis.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The imaging element of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

According to the method of the present invention the above described imaging element is image-wise exposed and subsequently developed according to the DTR-process. The DTR mono-sheet imaging element in connection with the present invention is exposed in an apparatus according to its particular application, e.g. a conventional process camera containing a conventional light source or a high intensity short time exposure such as e.g. a laser containing device.

The alkaline processing liquid used for developing the imaging element in accordance with the method of the present invention preferably contains at least part of the silver halide solvent(s). Preferably the silver halide solvent is used in an amount between 0.01% by weight and 10% by weight and more preferably between 0.05% by weight and 8% by weight. Suitable silver halide solvents for use in connection with the present invention are e.g. 2-mercaptobenzoic acid, cyclic imides, oxazolidones, thiocyanates and thiosulfates. Further silver halide solvents that can be used in connection with the present invention are alkanolamines.

Alkanolamines that are suitable for use in accordance with the present invention may be of the tertiary, secundary or primary type. Examples of alkanolamines that may be used in connection with the present invention correspond to the following formula: 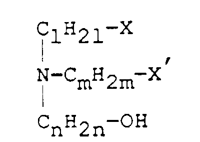 wherein X and X' independently represent hydrogen, a hydroxyl group or an amino group, l and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.

According to the present invention the alkanolamines are preferably present in the alkaline processing liquid in a concentration preferably between 0.1% and 10% by weight. However part or all of the alkanolamine can be present in one or more layers of the imaging element.

A further suitable type of silver halide solvents are thioether compounds. Preferably used thioethers correspond to the following general formula:

Z-(R¹-S)ₜ-R²-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R² and R³ each independently represents an alkylene that may be substituted and optionally contain a oxygen bridge and t represents an integer from 0 to 10.

Examples of thioether compounds corresponding to the above formula are disclosed in e.g. US-P-4.960.683 and specific examples are listed in table 1

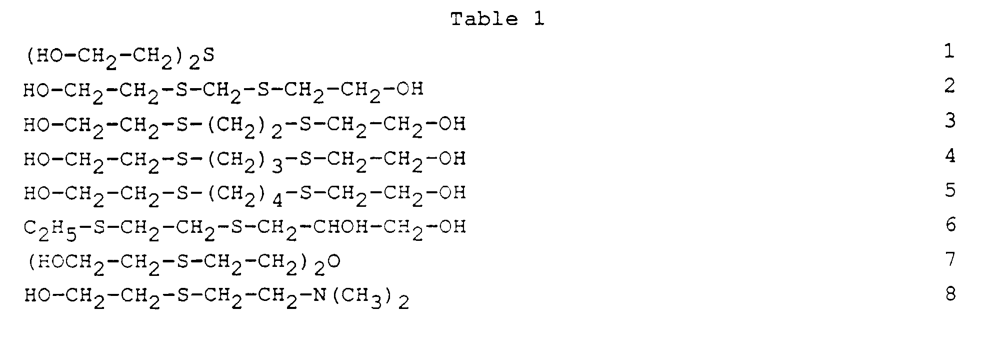

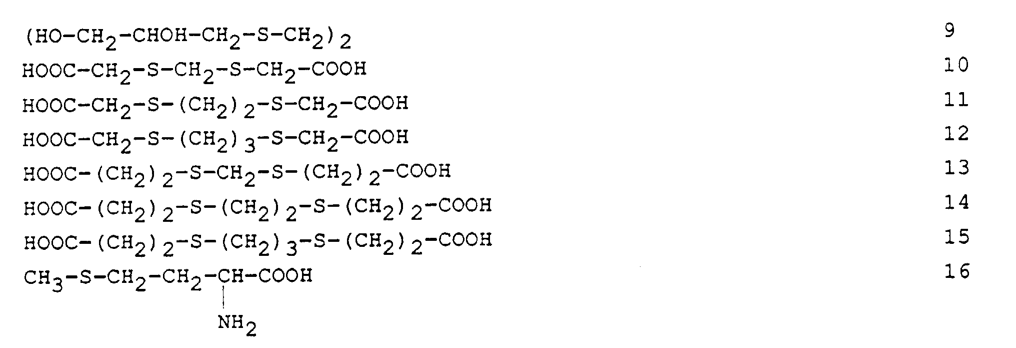

According to the present invention the alkaline processing liquid preferably also contains hydrophobizing agents for improving the hydrophobicity of the silver image obtained in the image receiving surface layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, and US-P 4,563,410.

According to the present invention the hydrophobizing agents are contained in the alkaline processing liquid in an amount of at least 0.1g/l, more preferably at least 0.2g/l and most preferably at least 0.3g/l. The maximum amount of hydrophobizing agents will be determined by the type of hydrophobizing agent, type and amount of silver halide solvents. Typically the concentration of hydrophobizing agent is preferably not more than 1.5g/l and more preferably not more than 1g/l.

According a particularly preferred embodiment in connection with the present invention, yielding particularly good printing plates, the alkaline processing liquid contains a meso-ionic compound as a regulating compound. Meso-ionic compounds as referred to in the present invention are a group of compounds defined by W. Baker and W.D. Ollis as "5- or 6-membered heterocyclic compounds which cannot be represented satisfactorily by any one covalent or polar structure and possesses a sextet of π-electrons in association with the atoms comprising the ring. The ring bears a fractional positive charge balanced by a corresponding negative charge located on a covalently attached atom or group of atoms" as described in Quart. Rev., Vol. 11, p. 15 (1957) and Advances in Heterocyclic Chemistry, Vol. 19, P. 4 (1976).

Preferred meso-ionic compounds are those represented by formula (I):

M⁺―A⁻ (I)

wherein M represents a 5- or 6-membered heterocyclic ring composed of at least one member selected from the group consisting of a carbon atom, a nitrogen atom, an oxygen atom, a sulfur atom and a selenium atom; and A⁻ represents -O⁻, -S⁻ or -N⁻-R, wherein R represents an alkyl group (preferably having 1 to 6 carbon atoms), a cycloalkyl group (preferably having 3 to 6 carbon atoms), an alkenyl group (preferably having 2 to 6 carbon atoms) an alkynyl group (preferably having 2 to 6 carbon atoms), an aralkyl group, an aryl group (preferably having 6 to 12 carbon atoms), or a heterocyclic group (preferably having 1 to 6 carbon atoms).

In formula (I), examples of the 5-membered heterocyclic ring as represented by M include an imidazolium ring, a pyrazolium ring, an oxazolium ring, an isoxazolium ring, a thiazolium ring, an isothiazolium ring, a 1,3-dithiol ring, a 1,3,4- or 1,2,3 oxadiazolium ring, a 1,3,2-oxathiazolium ring, a 1,2,3-triazolium ring, a 1,3,4-triazolium ring, a 1,3,4-, 1,2,3- or 1,2,4-thiadiazolium ring, a 1,2,3,4-oxatriazolium ring, a 1,2,3,4-tetrazolium ring and a 1,2,3,4-thiatriazolium ring.

Preferred meso-ionic compounds for use in accordance with the present invention are triazolium thiolates and more preferably 1,2,4-triazolium-3-thiolates and most peferably those that correspond to the following formula: 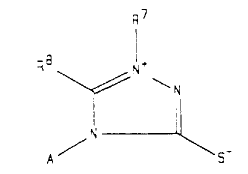 wherein R⁷ and R⁸ each independently represents an alkyl group, alkenyl group, cycloalkyl group, aralkyl group, aryl group or heterocyclic group each of which groups may be substituted or not, A represents an alkyl group, alkenyl group, cycloalkyl group, aralkyl group, aryl group, heterocyclic group each of which groups may be substituted or represents -NR⁹R¹⁰ wherein R⁹ and R¹⁰ each independently represents hydrogen, a substituted or unsubstituted alkyl group or a substituted or unsubstituted aryl group or wherein R⁷ and R⁸ or R⁸ and A or R⁹ and R¹⁰ together with the atoms to which they are attached represent the necessary atoms to form a 5- or 6-membered ring.

Specific examples of 1,2,4-triazolium-3-thiolates suitable for use in accordance with the present invention are shown in table 1.

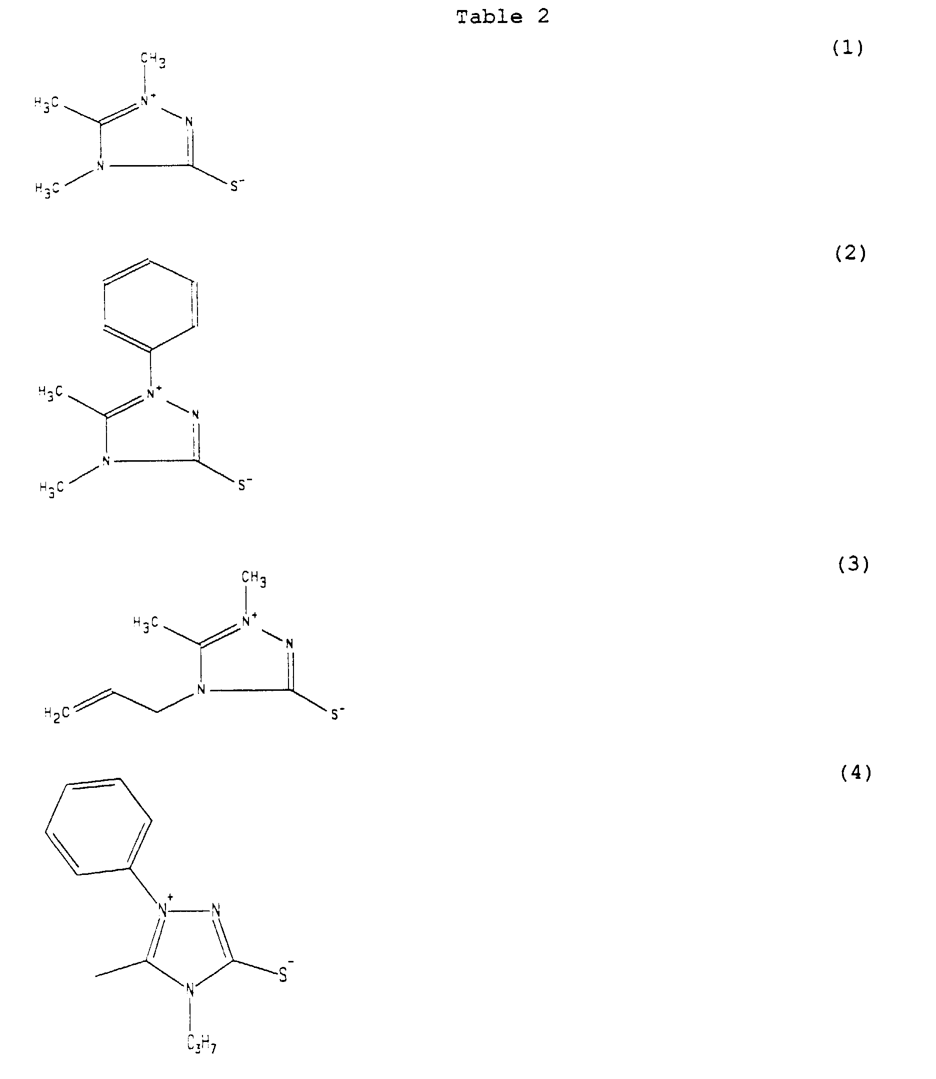

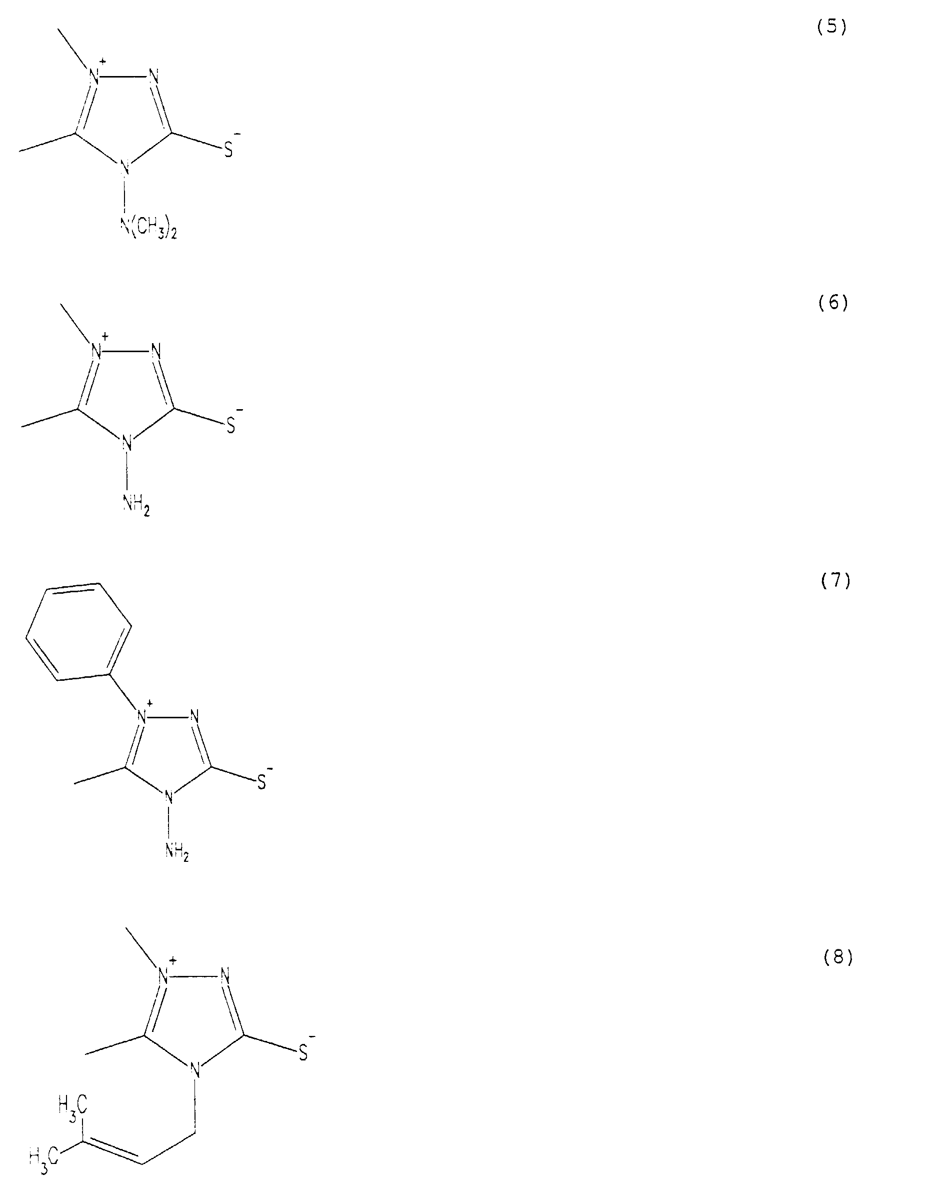

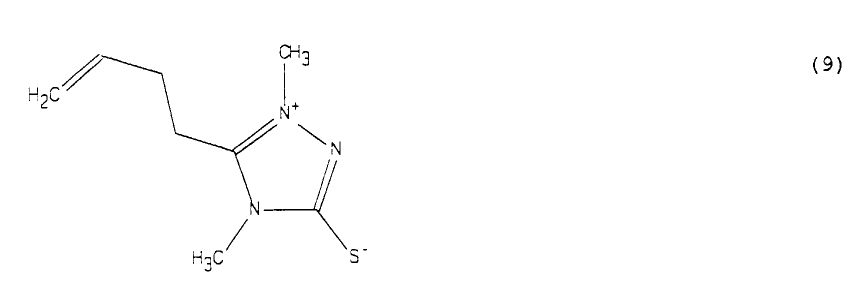

According to a preferred embodiment of the present invention at least part and most preferably all of the meso-ionic compound is preferably present in the alkaline processing liquid used for developing the image-wise exposed imaging element. Preferably the amount of meso-ionic compound in the alkaline processing liquid is between 0.1 mmol/l and 25 mmol/l and more preferably between 0.5 mmol/l and 15 mmol/l and most preferably between 1 mmol/l and 8 mmol/l.

However the meso-ionic compound may be incorporated in one or more layers comprised on the support of the imaging element. This offers the advantage of replenishment of said meso-ionic compound in the alkaline processing liquid. Preferably the meso-ionic compound is incorporated in a layer of the imaging element that does not contain silver halide such as e.g. in a backing layer, a subbing layer. The meso-ionic compound is preferably contained in the imaging element in a total amount between 0.1 and 10mmol/m², more preferably between 0.1 and 0.5mmol/m² and most preferably between 0.5 and 1.5mmol/m².

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate. Suitable organic alkaline substances are e.g. alkanolamines. In the latter case the alkanolamines will provide or help maintain the pH and serve as a silver halide complexing agent.

The alkaline processing liquid may also contain the developing agent(s) used in accordance with the present invention. In this case the alkaline processing liquid is called a developer. On the other hand some or all of the developing agent(s) may be present in one or more layers of the imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidincne-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

Subsequent to the development in an alkaline processing liquid the surface of the printing plate is preferably neutralized using a neutralization liquid.

A neutralization liquid generally has a pH between 5 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups.

The invention will now be illustrated by the following examples without however the intention to limit the invention thereto. All parts are by weight unless otherwise specified.

### EXAMPLE 1

### Preparation of the silver halide emulsion coating solution.

A silver chlorobromide emulsion composed of 98.2mol% of chloride and 1.8mol% of bromide was prepared by the double jet precipitation method. The average silver halide grain size was 0.4µm (diameter of a sphere with equivalent volume) and contained Rhodium ions as internal dopant. The emulsion was orthochromatically sensitized and stabilized by a 1-phenyl-5-mercapto-tetrazole.

### Preparation of a comparitive imaging element

A polyethylene terephthalate film support provided with a hydrophilic adhesion layer was coated with a subbing layer containing gelatine having an iso-electric point of 4.8. The layer was coated at a pH of 4.6.

An emulsion prepared as described above was coated to this coated polyethylene terephthalate film support together with a base layer such that the amount of gelatin in the base layer was 2.7g/m² and 1.34g/m² for the silver halide emulsion layer. The amount of silver halide expressed as AgNO₃ was 1.25g/m² and the emulsion layer further contained developing agents and 80mg/m² of formaldehyde as a hardener. The base layer further contained a silica matting agent having an average particle size of 3.4µm and carbon black as anti-halation means. The pH of the base layer and silver halide emulsion layer was respectively 4.8 and 4.2.

The thus obtained element was kept at 57 °C at a relative humidity of 34% for 1 day.

To a thus obtained element was then coated a surface layer of PdS nuclei serving as physical development nuclei. This surface layer also contained 0.4g/m² of hydroquinone and 100mg of formaldehyde. The material was then stored for 1 day at 57°C at a relative humidity of 34%.

### Preparation of an imaging element according to the invention:

An imaging element according to the present invention was prepared similar to the comparitive imaging element with the exception however that the subbing layer was coated at a pH of 8.7.

The following alkaline processing solution was prepared:

| | |
|---|---|
| sodium hydroxide (g) | 30 |
| sodium sulphite anh. (g) | 35 |
| compound 9 of table 2 (g) | 1.2 |
| 2-aminoethyl-aminoethanol (ml) | 45 |
| 2-mercapto-5-n.heptyl-oxa-3,4-diazole (mg) | 350 |
| water to make | 1000ml |

The following neutralization solution was prepared:

| | |
|---|---|
| citric acid | 10 g |
| sodium citrate | 35 g |
| sodium sulphite anh. | 5 g |
| phenol | 50 mg |
| water to make | 1 l |

The following dampening liquid was prepared:

| | |
|---|---|
| water | 880 ml |
| citric acid | 6g |
| boric acid | 8.4g |
| sodium sulphate anh. | 25g |
| ethyleneglycol | 100g |
| colloidal silica | 28g |

The above described imaging elements were image-wise exposed and processed at 30°C with the above described alkaline processing solution, subsequently neutralized at 25 °C with the neutralization solution described above and dried.

The printing plates thus prepared were mounted on an offset printing machine. The ink used was a commonly employed ink. During the printing run the above described dampening solution was used. The printing endurance, i.e. the number of acceptable copies was then evaluated. It was found that the printing plate obtained from the compartive imaging element yielded less than 3000 acceptable copies whereas the printing plate obtained from the imaging element according to the present invention could yield more than 7000 copies (the printing was stopped after 7000 copies).

### EXAMPLE 2

A comparitive imaging element was prepared similar to the procedure described for the comparitive imaging element of example 1 with the exception that instead of a polyethylenetherephthale film support a polyethylene coated paper was used.

An imaging element according to the invention was prepared similar to the comparitive imaging element described in the previous paragraph with the exception that the subbing layer was coated at a pH of 5.6.

The thus obtained imaging elements were developed as described in example 1 and the obtained printing plates were used to print as described in example 1. It was found that the printing plate obtained from the compartive imaging element yielded less than 3000 acceptable copies whereas the printing plate obtained from the imaging element according to the present invention could yield more than 5000 copies (the printing was stopped after 5000 copies).

## Claims

1. An imaging element comprising on a support in the order given (i) a subbing layer comprising gelatine, (ii) a base layer containing an anti-halation substance, (iii) a silver halide emulsion layer and (iv) a image receiving layer containing physical development nuclei characterised in that said subbing layer has a pH above the iso-electric point of the gelatine used in said subbing layer.

2. An imaging element according to claim 1 wherein said subbing layer is contiguous to said base layer.

3. An imaging element according to claim 1 or 2 wherein said subbing layer contains gelatine in an amount of 0.1g/m² to 1.5g/m².

4. An imaging element according to any of claims 1 to 3 wherein base layer comprises a matting agent having an average diameter between 2 and 10µm.

5. An imaging element according to any of claims 1 to 4 wherein said anti-halation substance is carbon black.

6. A method for making a lithographic printing plate according to the silver salt diffusion transfer process comprising the steps of image-wise exposing an imaging element as defined in any of the above claims and subsequently developing a thus obtained image-wise exposed imaging element using an alkaline processing solution in the presence of a developing agent and a silver halide solvent.

7. A method according to claim 6 wherein said alkaline processing solution comprises a meso-ionic compound.

8. A method according to claim 6 or 7 wherein said silver halide solvent is selected from the group consisting of an alkanolamine, a thioether.

9. A method according to any of the claims 6 to 8 wherein said image-wise exposure is a high intensity short time exposure.

## Patentansprüche

1. Ein Bilderzeugungselement, das auf einem Träger der angegebenen Reihe nach (i) eine Gelatine enthaltende Haftschicht, (ii) eine eine Lichthofschutzsubstanz enthaltende Grundierschicht, (iii) eine Silberhalogenidemulsionsschicht und (iv) eine physikalische Entwicklungskeime enthaltende Bildempfangsschicht enthält, dadurch gekennzeichnet, daß die Haftschicht einen pH über dem isoelektrischen Punkt der in der Haftschicht benutzten Gelatine aufweist.

2. Bilderzeugungselement nach Anspruch 1, dadurch gekennzeichnet, daß die Haftschicht an die Grundierschicht grenzt.

3. Bilderzeugungselement nach Anspruch 1 oder 2, dadurch gekennzeichnet, daß die Haftschicht Gelatine in einer Menge zwischen 0,1 g/m² und 1,5 g/m² enthält.

4. Bilderzeugungselement nach irgendeinem der Ansprüche 1 bis 3, dadurch gekennzeichnet, daß die Grundierschicht ein Mattiermittel mit einem durchschnittlichen Durchmesser zwischen 2 und 10 µm enthält.

5. Bilderzeugungselement nach irgendeinem der Ansprüche 1 bis 4, dadurch gekennzeichnet, daß die Lichthofschutzsubstanz Gasruß ist.

6. Ein Verfahren zur Herstellung einer lithografischen Druckplatte gemäß dem Silbersalzdiffusionsübertragungsverfahren, das die Stufen der bildmäßigen Belichtung eines in irgendeinem der obigen Ansprüche definierten Bilderzeugungselements und der darauffolgenden Entwicklung eines so erhaltenen bildmäßig belichteten Bilderzeugungselements mittels einer alkalischen Verarbeitungslösung in Gegenwart eines Entwicklers und eines Silberhalogenidlösungsmittels umfaßt.

7. Verfahren nach Anspruch 6, dadurch gekennzeichnet, daß die alkalische Verarbeitungslösung eine mesoionische Verbindung enthält.

8. Verfahren nach Anspruch 6 oder 7, dadurch gekennzeichnet, daß das Silberhalogenidlösungsmittel ein Alkanolamin oder ein Thioether ist.

9. Verfahren nach irgendeinem der Ansprüche 6 bis 8, dadurch gekennzeichnet, daß die bildmäßige Belichtung eine hochintensive Kurzbelichtung ist.

## Revendications

1. Elément formateur d'image comprenant, sur un support, dans l'ordre donné, (i) une couche adhérente comprenant de la gélatine, (ii) une couche de base contenant une substance antihalo, (iii) une couche d'émulsion à l'halogénure d'argent et (iv) une couche réceptrice d'image contenant des germes de développement physique, caractérisé en ce que ladite couche adhérente possède un pH supérieur au point isoélectrique de la gélatine utilisée dans ladite couche adhérente.

2. Elément formateur d'image selon la revendication 1, dans lequel ladite couche adhérente est contiguë à ladite couche de base.

3. Elément formateur d'image selon la revendication 1 ou 2, dans lequel ladite couche adhérente contient de la gélatine en une quantité de 0,1 g/m² à 1,5 g/m².

4. Elément formateur d'image selon l'une quelconque des revendications 1 à 3, dans laquelle la couche de base comprend un agent de matage possédant un diamètre moyen entre 2 et 10 µm.

5. Elément formateur d'image selon l'une quelconque des revendications 1 à 4, dans lequel ladite substance antihalo est le noir de carbone.

6. Procédé pour fabriquer un cliché d'impression lithographique conformément au procédé de transfert de sels d'argent par diffusion, comprenant les étapes consistant à exposer en forme d'image un élément formateur d'image tel que défini dans l'une quelconque des revendications ci-dessus et à développer par la suite un élément formateur d'image ainsi obtenu, exposé en forme d'image en utilisant une solution de traitement alcaline en présence d'un agent développateur et d'un solvant de l'halogénure d'argent.

7. Procédé selon la revendication 6, dans lequel ladite solution de traitement alcalin comprend un composé méso-ionique.

8. Procédé selon la revendication 6 ou 7, dans lequel ledit solvant de l'halogénure d'argent est choisi parmi le groupe constitué par une alcanolamine et par un thioéther.

9. Procédé selon l'une quelconque des revendications 6 à 8, dans lequel ladite exposition en forme d'image est une exposition de courte durée à intensité élevée.
